# EUROPEAN PATENT SPECIFICATION

(11) **EP 0 590 463 B1**
(45) Date of publication and mention of the grant of the patent: **10.07.2002**
(21) Application number: 93115110.4
(22) Date of filing: 20.09.1993
(51) Int. Cl.: C08G 59/06, C08L 63/00, B32B 15/20, B32B 27/38, B32B 15/08

(54) **Halogen containing epoxy resin composition and copper-clad laminate**
Halogen enthaltende Epoxidharzzusammensetzung und kupferkaschiertes Laminat
Composition de résine époxyde contenant des halogènes et un laminé revêtu de cuivre

(30) Priority: 22.09.1992 JP 25280692; 05.11.1992 JP 29585892; 05.11.1992 JP 29585992
(43) Date of publication of application: 06.04.1994
(73) Proprietor: SUMITOMO CHEMICAL COMPANY LIMITED, Osaka-shi, Osaka 541-0041 (JP)
(72) Inventor: Ueda, Yoichi, Ibaraki 305 (JP); Endo, Yasuhiro, Ibaraki 305 (JP); Shibata, Mitsuhiro, Tsukuba-shi Ibaraki 305 (JP); Kamio, Kunimasa, Toride-shi Ibaraki 302 (JP); Kitayama, Shinichiro, Tsukuba-shi Ibaraki 305 (JP); Yamasaki, Kaori, Ushiku-shi Ibaraki 300-12 (JP); Hayashi, Toshiaki, Ibaraki 305 (JP)
(74) Representative: VOSSIUS & PARTNER

(56) References cited:
- EP-A- 0 133 600
- EP-A- 0 251 431
- EP-A- 0 293 237
- EP-A- 0 372 983
- EP-A- 0 498 505
- GB-A- 2 211 852
- CHEMICAL ABSTRACTS, vol. 120, no. 2, 10 January 1994, Columbus, Ohio, US; abstract no. 10028, & PATENT ABSTRACTS OF JAPAN vol. 17, no. 492 (C-1107) & JP-A-05 125 149 (SUMITOMO CHEMICAL CO.) 21 May 1993
- CHEMICAL ABSTRACTS, vol. 119, no. 18, 1 November 1993, Columbus, Ohio, US; abstract no. 182174, & PATENT ABSTRACTS OF JAPAN vol. 17, no. 540 (C-1115) & JP-A-05 148 344 (SUMITOMO CHEMICAL CO.) 15 June 1993
- CHEMICAL ABSTRACTS, vol. 115, no. 26, 30 December 1991, Columbus, Ohio, US; abstract no. 281671, & PATENT ABSTRACTS OF JAPAN vol. 15, no. 450 (C-0885) & JP-A-03 192 112 (MITSUI PETROCHEMICAL IND., LTD.) 22 August 1991
- PATENT ABSTRACTS OF JAPAN vol. 11, no. 365 (C-460) & JP-A-62 135 539 (SANYO KOKUSAKU PULP CO. LTD.) 18 June 1987

## Description

The present invention relates to an epoxy resin composition and a copper-clad laminate and particularly to an epoxy resin composition superior in low dielectric constant and a copper-clad laminate made therefrom,

Hitherto, among epoxy resins utilized for electrical and electronic uses, bisphenol type epoxy resins and dicyandiamide have been mainly used in combination as the materials of substrates for printed circuit boards. Recently, resins of low dielectric constant have been demanded mainly for the purpose of improving signal speed with increase in the number of layers of printed circuit boards and it has been proposed to combine low dielectric thermoplastic resins with conventional epoxy resins. The proposals are, for example, to modify epoxy resins with reactive polybutadiene resins, to disperse powders of polytetrafluoroethylene resins and to use aramid fibers as a substrate. Another proposal is use of D-glass or quartz lower in dielectric constant than the conventionally used E-glass as a substrate.

EP-A-498 505 relates to an epoxy resin composition for use in electrical laminates comprising an epoxy resin, a curing agent, curing accelerator and a solvent, said epoxy resin comprising as the principal component a particular epoxy resin having a hydrolyzable halogen content of 0.03% by weight and obtained by reacting (I) a bisphenol A-type epoxy resin, (II) a glycidyl-etherified polycondensation product of bisphenol A and formaldehyde, having a softening point not higher than 50°C and (III) tetrabromobisphenol A wherein the amount of said glycidyl-etherified compound (II) lies in the range of from 30% to 1% by weight based on the total weight of the resin.

EP-A-133 600 relates to an epoxy resin composition comprising a polyglycidyl ether prepared by reacting a 3-methyl-6-alkylphenol in the presence or absence of a phenol other than the 3-methyl-6-alkylphenol with an aldehyde to obtain a novolak and then reacting the novolak with an epihalohydrin which composition is useful in electronic fields for example for encapsulating semiconductor products or for the production of printed circuit boards.

EP-A-293 237 relates to an epoxy compound having a chemical structure in which an aromatic ring having a glycidyl radical attached thereto has a tertiary alkyl radical at its ortho or meta-position. An epoxy resin composition comprising the epoxy compound, a curing agent and a curing accelerator cures into product having a low dielectric constant.

However, according to these conventional methods the proportion of the thermoplastic resins combined with epoxy resins must be increased for attaining the desired dielectric constant because the dielectric constant of the base epoxy resins is high. Thus, heat resistance, dimensional stability and chemical resistance which are features of epoxy resins are lost. Use of aramid fibers or quartz suffers from the problem that the drill used at the time of drilling to make holes through the substrate wears out. When D-glass is used, there is no problem in drilling, but production cost is high.

Under these circumstances, epoxy resins of low dielectric constant from which substrates for printed circuit boards which have low dielectric constant can be obtained in the same manner as by conventional methods have been earnestly desired. The object of the present invention is to provide epoxy resin compositions excellent in heat resistance and low in dielectric constant and copper-clad laminates made by molding the compositions.

The above object could be solved after investigating the matrix structure of epoxy resins and characteristics of laminates obtained therefrom by the finding that a specific composition has both the excellent heat resistance and the low dielectric constant.

The present invention relates to the subject-matter disclosed in the claims.

That is, the invention relates in a first embodiment to an epoxy resin composition comprising:
(1) a compound obtainable by previously reacting (A) an epoxy resin in an amount of from 30-95% by weight based on a total resin weight, said epoxy resin being obtainable by glycidyl etherifying a 3-methyl-6-(C₄-C₈)alkylphenol novolak represented by formula (4) as disclosed in claim 1 with (B) a halogen-containing bisphenol compound in an amount sufficient to attain a UL flame retardancy rating of V-O, said halogen-containing bisphenol compound represented by the following formula (1): 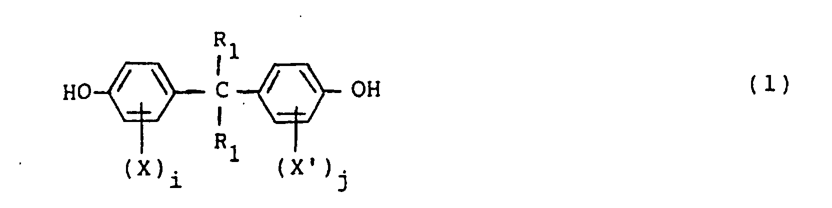 wherein R₁ represents a hydrogen atom or a methyl group and the two R₁ may be identical or different, X and X' represent halogen atom and may be identical or different, and i and j independently of one another are integers of 1 to 4, and
(2) an epoxy hardener.

The invention relates in a second embodiment to an epoxy resin composition comprising:
(1) a compound obtainable by previously reacting (A) the epoxy resin used in the first embodiment of this invention, (B) the halogen-containing bisphenol compound used in the first embodiment of this invention and (C) a glycidyl etherified product of a halogen-containing bisphenol compound which is represented by the following formula (2): 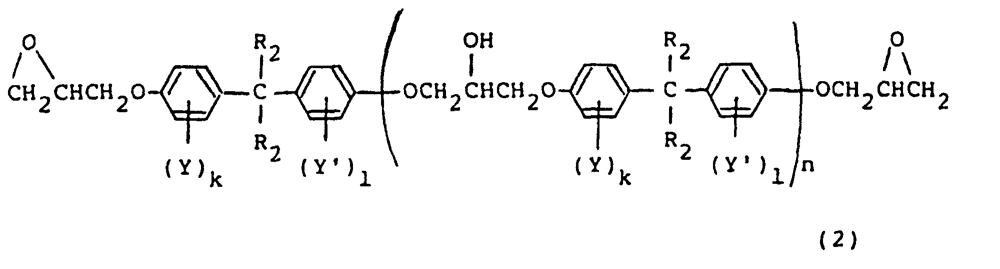 wherein R₂ represents a hydrogen atom or a methyl group and the two R₂ may be identical or different, Y and Y' represent halogen atom and may be identical or different, n represents an average recurring unit number and is 0 to 10 and k and l independently of one another are integers of 1 to 4, and
(2) an epoxy hardener.

The invention in a third embodiment relates to an epoxy resin copper-clad laminate made by heat molding a copper foil and a prepreg obtained by impregnating a substrate with a solution of the epoxy resin composition of the first or second embodiment of the invention in an organic solvent.

The epoxy resin of the component (A) used in the present invention is obtainable by glycidyl etherification of a 3-methyl-6-(C₄-C₈)alkylphenol novolak.

The 3-methyl-6-(C₄-C₈)alkylphenol novolak is prepared by the process ordinarily used for preparing novolak type phenolic resins. For example, it is prepared by polycondensation of a 3-methyl-6-(C₄-C₈)-alkylphenol with an aldehyde using as a catalyst an inorganic acid such as hydrochloric acid, phosphoric acid or sulfuric acid, an organic acid such as benzenesulfonic acid, toluenesulfonic acid or oxalic acid or a metallic salt such as zinc acetate.

The alkyl group of the 3-methyl-6-(C₄-C₈)-alkylphenol includes, for example, various isomers of butyl group, pentyl group, hexyl group, heptyl group and octyl group. Among them, preferred are t-butyl group and sec-butyl group from the economical viewpoints such as easiness in availability of starting materials.

Examples of the aldehyde are formaldehyde, acetaldehyde and propionaldehyde and formaldehyde is preferred from the economical viewpoint.

The recurring unit number of the phenol component and the aldehyde of the 3-methyl-6-(C₄-C₈)alkylphenol novolak is defined by r in the following formula (4): 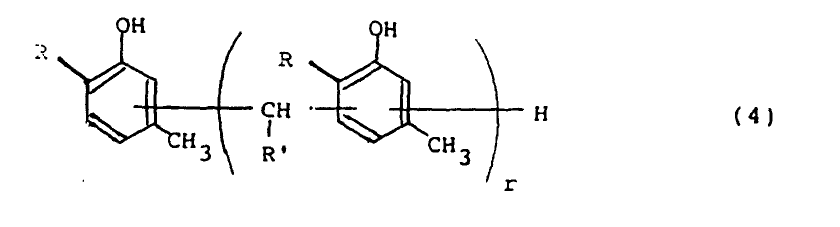 wherein R represents a C₄-C₈ alkyl group and R' represents an aldehyde residue.

The value r is 1.1-3 on an average. If the recurring unit number exceeds 5 on an average, viscosity of the epoxy resin increases and workability at the time of making the laminate deteriorates. If it is less than 1 on an average, heat resistance of the laminate made using the resin decreases.

The glycidyl etherification of 3-methyl-6-(C₄-C₈)alkylphenol novolak is carried out by known processes. For example, it is carried out by allowing this novolak to react with epichlorohydrin in the presence of an alkali such as sodium hydroxide.

Examples of the halogen-containing bisphenol compound used in the present invention as the component (B) which is represented by the formula (1) are tetrabromobisphenol A, tetrachlorobisphenol A, tetraiodobisphenol A, tetrabromobisphenol F, tetrachlorobisphenol F, tribromobisphenol A and 2,2'-dibromobisphenol A and among them, tetrabromobisphenol A is preferred from the economical viewpoint and for obtaining efficient flame retardance.

Examples of the glycidyl etherification product of halogen-containing bisphenol compound used in the present invention as the component (C) which is represented by the formula (2) are those which are obtained by glycidyl etherifying the above-mentioned halogen-containing bisphenol compounds and glycidyl ether of tetrabromobisphenol A is preferred from the economical viewpoint and for obtaining efficient flame retardance.

The reaction of the epoxy resin (A) with the halogen-containing bisphenol compound (B) or the reaction of the (A) and the (B) with the glycidyl etherification product (C) of the halogen-containing bisphenol compound can be carried out by known processes.

For example, the above components can be allowed to react in the presence of a basic catalyst such as triphenylphosphine or imidazole. By the reaction, control of glass transition temperature owing to the change of distance between crosslinking points and impartation of flame retardance using the halogen-containing compound can be performed without causing volatilization of low molecular weight materials at the time of hardening.

The components (A) and (B) or (A), (B) and (C) can be allowed to react at optional ratios. The epoxy resin (A) is used in an amount of 30-95% by weight based on the whole resin for maintaining the low dielectric constant. The amount of the halogen-containing bisphenol compound (B) or that of the glycidyl etherification product (C) of halogen-containing bisphenol compound is desirably adjusted so that the content of the halogen atom is within such range as being able to attain V-0 in UL flame retardancy rating. For example, for bromine atom, it is desirable to determine the amount of these components so that bromine atom is contained in an amount of 15-30% by weight in the epoxy resin composition.

The reaction of the above components may be carried out with or without using solvents. If solvents are used, they may be general-purpose solvents. Examples of the solvents are ketones such as acetone, methyl ethyl ketone and methyl isobutyl ketone, hydrocarbons such as benzene, toluene and xylene, ethers such as tetrahydrofuran, dioxane and diethylene glycol dimethyl ether and alcohols such as methyl cellosolve and butyl cellosolve. Preferred are methyl ethyl ketone, toluene, xylene, butyl cellosolve, dioxane and diethylene glycol dimethyl ether.

The reaction temperature can be in the range of 50-200° C, but preferably in the range of 80-150° C for carrying out the reaction efficiently and inhibiting side reactions.

The epoxy hardeners used in the present invention may be known ones, but polybutadiene compounds modified with phenolic compounds and the dicyclopentadiene-phenol compounds represented by the following formula (3) are preferred for obtaining hardened resins of low dielectric constant. Amount of the hardener is preferably such that content of phenolic hydroxyl group is 0.3-1.2 equivalent per 1 equivalent of epoxy group in the epoxy resin. 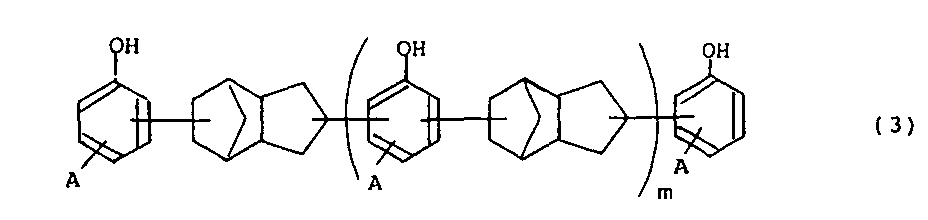 wherein m represents an average recurring unit number and is a numeral in the range of 0 to 10 and A represents a hydrogen atom or an alkyl group of 1 to 8 carbon atoms.

The polybutadiene compounds modified with phenolic compounds are obtained by allowing homopolymers of butadiene having a number-average molecular weight of 500-10000 or copolymers of butadiene with vinyl monomers such as styrene or diolefins such as isoprene to react with phenols. Examples of catalysts used are sulfuric acid, perchloric acid, aluminum chloride, boron trifluoride, boron trifluoride-ether complex and boron trifluoride-phenol complex. The phenols include, for example, monohydric phenols, polyhydric phenols and alkyl-substituted phenols.

General processes for producing the dicyclopentadiene-phenol compounds represented by the formula (3) include a process which comprises allowing phenols to react with dicyclopentadiene in the presence of an acid catalyst for Friedel-Craft's reaction (Japanese Patent Application Kokai No. 63-99224).

Furthermore, as far as the effects of the present invention are not damaged, there may be additionally used known bifunctional epoxy resins, polyfunctional epoxy resins, other thermosetting resins, thermoplastic resins having functional group and others. Examples thereof are glycidyl ether of bisphenol A, glycidyl ether of phenolic novolak, glycidyl ether of cresol novolak, glycidyl ether of brominated phenol novolak, unsaturated polyester resins, cyanate resins, maleimide resins, glycidyl-modified polybutadienes and maleic anhydride-modified polyethylenes.

These resins may be used by incorporating into the epoxy resin compositions of the present invention or by previously allowing them to react with the epoxy resins used in the present invention.

Known additives such as curing accelerator, flame retardant and surface treating agent may be added to the compositions depending on the object.

Examples of the curing accelerator are imidazoles, tertiary amines and phosphorus compounds, those of the flame retardants are antimony trioxide, aluminum hydroxide and red phosphorus, and those of the surface treating agent are silane coupling agents.

The copper-clad laminate of the present invention can be produced by known methods. That is, a substrate is impregnated with a resin varnish prepared by dissolving the epoxy resin composition of the present invention in an organic solvent and then the impregnated substrate is heat treated to obtain a prepreg. Thereafter, the prepreg and a copper foil are laminated and heat molded to make a copper-clad laminate.

The organic solvent used is selected from one or mixtures of acetone, methyl ethyl ketone, methyl isobutyl ketone, ethylene glycol monomethyl ether, propylene glycol monomethyl ether, toluene, xylene, N,N-dimethylformamide, dioxane, tetrahydrofuran and the like.

The substrate to be impregnated with resin varnish includes, for example, woven or nonwoven fabrics or mats comprising inorganic fibers or organic fibers such as glass fibers, polyester fibers and polyamide fibers and papers. These may be used each alone or in combination of two or more.

The heat treating conditions for making the prepreg can be optionally selected depending on the kinds of solvents, catalysts and additives used and amounts thereof, but usually the conditions of 80-220 ° C for 3-30 minutes are employed.

The heat molding conditions include, for example, hot press molding conducted at 150-300° C, under a molding pressure of 10-100 kg/cm² for 20-300 minutes.

In the following examples, "epoxy equivalent" is defined to be molecular weight of epoxy resin per one epoxy group; "OH equivalent" is defined to be molecular weight of OH compound per one OH group; and "Br content" is defined to be % by weight based on solid content of the resin.

### Preparation Example 1

This example concerns with preparation of a novolak resin which is a starting material for epoxy resin (A) as a constituting component of the resin composition of the present invention.

2-t-Butyl-5-methylphenol (2231.0 g, 13.58 mol), p-toluenesulfonic acid (12.9 g, 0.068 mol) and deionized water (223.2 g) were charged in a 5 liter four-necked round flask equipped with a thermometer, a stirrer and a condenser and heated to 100 ° C. Formaldehyde (218.4 g, 2.715 mol) was added dropwise thereto using a dropping tube over a period of 2 hours and then kept at 100° C for 2 hours to carry out the reaction for preparing a novolak. Thereafter, the reaction mixture was cooled to 80 ° C and neutralized with 10% aqueous NaOH solution (27.7 g, 0.069 mol). The organic layer obtained by separation was washed twice with deionized water (700 g). The organic layer after washed was subjected to concentration under reduced pressure (180 ° C 1333 Pa (10 mmHg)/ 1 hour) to obtain a resinous product (857.2 g). OH equivalent of the resulting resinous product was 176.0 g/eq. The recurring unit number ( r in the formula (4)) of this novolak resin was 1.25 on an average.

### Preparation Example 2

This example concerns with preparation of an epoxy resin by the reaction of the novolak resin obtained in Preparation Example 1 with epichlorohydrin.

The novolak resin obtained in Preparation Example 1 (246.4 g, 1.4 equivalent), epichlorohydrin (906.5 g, 9.8 mol), dimethyl sulfoxide (453.3 g) and deionized water (14.0 g) were charged in a 2 liter four-necked round flask equipped with a thermometer, a stirrer and a condenser with a separating pipe and 48.6% aqueous sodium hydroxide solution (108.31 g, 1.316 mol) was added dropwise thereto over a period of 5 hours under the conditions of 49° C, 5.6 kPa (42 Torr), during which the reaction was allowed to proceed with keeping the temperature at 49 ° C and with cooling and liquefying the azeotropic epichlorohydrin and water and with returning the organic layer to the reaction system.

After completion of the reaction, unreacted epichlorohydrin was removed by concentration under reduced pressure and the epoxidized product containing by-produced salts and dimethyl sulfoxide was dissolved in methyl isobutyl ketone and the by-produced salts and dimethyl sulfoxide were removed by washing with warm water. The solvent was removed under reduced pressure to obtain an epoxy resin (304.9 g).

Epoxy equivalent of the resulting epoxy resin was 256 g/eq. It was confirmed by infrared absorption spectrum that absorption 3200-3600 cm ⁻¹ of phenolic OH disappeared and there were absorptions of 1240, 910 cm ⁻¹ of epoxide.

### Preparation Example 3

This example relates to preparation of a terminal epoxy resin having a bromine content of 20% by addition reaction of the epoxy resin obtained in Preparation Example 2 with diglycidyl ether of tetrabromobisphenol A and tetrabromobisphenol A.

The epoxy resin obtained in Preparation Example 2 (62.0 g), diglycidyl ether of tetrabromobisphenol A (Sumiepoxy ESB-400 having an epoxy equivalent of 403 g/eq manufactured by Sumitomo Chemical Co., Ltd., 25.3 g) and tetrabromobisphenol A (12.7 g) were charged in a 300 ml four-necked round flask equipped with a thermometer, a stirrer, a condenser tube and molten by heating at 110° C. Thereafter, a solution prepared by dissolving triphenylphosphine (40 mg, 4 × 10 ⁻⁴ wt% based on resin) in methyl ethyl ketone (2.25 g) was added and the mixture was kept at 110 ° C for 4 hours to carry out the addition reaction between the epoxy group and the phenolic hydroxyl group. After completion of the reaction, the reaction system was cooled to 90° C and methyl ethyl ketone (22.75 g) was added dropwise to obtain a resin solution (123.9 g, resin solid content 80.62 wt%). Epoxy equivalent of the resulting resin adduct was 399.0 g/eq.

### Preparation Example 4

This example relates to preparation of a terminal epoxy resin having a bromine content of 27% by the addition reaction of the epoxy resin obtained in Preparation Example 2 with diglycidyl ether of tetrabromobisphenol A and tetrabromobisphenol A.

The epoxy resin obtained in Preparation Example 2 (132.6 g), diglycidyl ether of tetrabromobisphenol A (Sumiepoxy ESB-400 having an epoxy equivalent of 403 g/eq manufactured by Sumitomo Chemical Co., Ltd., 119.5 g) and tetrabromobisphenol A (279.0 g) were charged in a 500 ml four-necked round flask equipped with a thermometer, a stirrer and a condenser tube and molten by heating at 110° C. Thereafter, a solution prepared by dissolving triphenylphosphine (112 mg, 4× 10⁻⁴ wt% based on resin) in methyl ethyl ketone (0.30 g) was added and the mixture was kept at 110° C for 4 hours to carry out the addition reaction between the epoxy group and the phenolic hydroxyl group. After completion of the reaction, the reaction system was cooled to 90° C and methyl ethyl ketone (73.5 g) was added dropwise to obtain a resin solution (349.2 g, resin solid content 79.80 wt%). Epoxy equivalent of the resulting resin adduct was 388.0 g/eq.

### Example 1

The epoxy resin obtained in Preparation Example 3, dicyandiamide and 2-ethyl-4-methylimidazole were mixed at the ratio as shown in Table 1 and the mixture was dissolved in a mixed solvent of methyl ethyl ketone and ethylene glycol monomethyl ether to prepare a homogeneous resin varnish. A glass cloth (KS-1600S962LP manufactured by Kanebo Ltd.) was impregnated with the varnish and treated at 150 ° C for 5-10 minutes by a hot-air dryer to obtain a prepreg. Five prepregs and a copper foil (subjected to TSTO treatment; 35 µ thick, manufactured by Furukawa Circuit Foil Co.) were stacked and hot press molded under the conditions of 170° C × 50 kg/cm² × 120 minutes to obtain a copper-clad laminate of 1 mm thickness. Peeling strength of the copper foil of the laminate and solder resistance were measured in accordance with JIS-C-6481. Glass transition temperature (Tg) was obtained from the inflexion point of an expansion curve using a thermal apparatus DT-30 manufactured by Shimadzu Seisakusho Ltd. Dielectric constant and dissipation factor at room temperature were measured using 4275 MultiFrequency LCR meter manufactured by Yokogawa Hewlett Packard Co. and the value of dielectric constant was calculated from electric capacity. The results are shown in Table 1.

### Example 2

The epoxy resin obtained in Preparation Example 4, a phenol novolak resin (Tamanol 758 manufactured by Arakawa Chemical Co., Ltd.) and 2-ethyl-4-methylimidazole were mixed at the ratio as shown in Table 1 and the mixture was dissolved in methyl ethyl ketone to prepare a homogeneous resin varnish. A copper-clad laminate of 1 mm thickness was obtained using the resulting varnish in the same manner as in Example 1. The properties of the laminate were also measured in the same manner as in Example 1. The results are shown in Table 1.

### Example 3

The epoxy resin obtained in Preparation Example 4, diglycidyl ether of tetrabromobisphenol A (Sumiepoxy ESB-400 manufactured by Sumitomo Chemical Co., Ltd.; epoxy equivalent: 403 g/eq), a phenol-modified polybutadiene resin (PP-700-300 manufactured by Nippon Oil Chemical Co., Ltd.; OH equivalent: 317 g/eq, softening point:149 ° C) and 2-ethyl-4-methylimidazole were mixed at the ratio as shown in Table 1 and the mixture was dissolved in methyl ethyl ketone to prepare a homogeneous resin varnish. A copper-clad laminate of 1 mm thickness was obtained using the resulting varnish in the same manner as in Example 1. The properties of the laminate were also measured in the same manner as in Example 1. The results are shown in Table 1.

### Example 4

The epoxy resin obtained in Preparation Example 4, diglycidyl ether of tetrabromobisphenol A (Sumiepoxy ESB-400 manufactured by Sumitomo Chemical Co., Ltd.; epoxy equivalent: 403 g/eq), a dicyclopentadiene-phenol resin (DPP-600M manufactured by Nippon Oil Chemical Co., Ltd.; OH equivalent: 168 g/eq, softening point: 96 ° C) and 2-ethyl-4-methylimidazole were mixed at the ratio as shown in Table 1 and the mixture was dissolved in methyl ethyl ketone to prepare a homogeneous resin varnish. A copper-clad laminate of 1 mm thickness was obtained using the resulting varnish in the same manner as in Example 1. The properties of the laminate were also measured in the same manner as in Example 1. The results are shown in Table 1.

### Comparative Example 1

Brominated epoxy resin (Sumiepoxy ESB-500 manufactured by Sumitomo Chemical Co., Ltd.; epoxy equivalent: 472 g/eq) and a cresol novolak type epoxy resin (Sumiepoxy ESCN-220 manufactured by Sumitomo Chemical Co., Ltd.; epoxy equivalent: 215 g/eq) as the epoxy resins, dicyandiamide and 2-ethyl-4-methylimidazole were mixed at the ratio as shown in Table 1 and the mixture was dissolved in a mixed solvent of methyl ethyl ketone and ethylene glycol monomethyl ether to prepare a homogeneous resin varnish. A glass cloth (KS-1600S962LP manufactured by Kanebo Ltd.) was impregnated with the varnish and treated at 150 ° C for 5-10 minutes by a hot-air dryer to obtain a prepreg. Five prepregs and a copper foil (subjected to TSTO treatment; 35µ thick, manufactured by Furukawa Circuit Foil Co.) were stacked and hot press molded under the conditions of 160 ° C × 4.9 MPa (50 kg/cm²) × 90 minutes to obtain a copper-clad laminate of 1 mm thickness.

The properties of the laminate were measured in the same manner as in Example 1 and the results are shown in Table 1.

**Table 1**

| | | Example 1 | Example 2 | Example 3 | Example 4 | Comparative Example 1 |
|---|---|---|---|---|---|---|
| Epoxy resin of Preparation Example 3 (solid content) | | 100 | | | | |
| | | | | | | |
| Epoxy resin of Preparation Example 4 (solid content) | | | 78.6 | 32.3 | 84.7 | |
| | | | | | | |
| Sumiepoxy ESB-400 | | | | 22.7 | 5.1 | |
| | | | | | | |
| Sumiepoxy ESB-500 | | | | | | 90 |
| | | | | | | |
| Sumiepoxy ESCN-220 | | | | | | 10 |
| | | | | | | |
| Dicyandiamide | | 2.63 | | | | 2.49 |
| | | | | | | |
| Tamanol 758 | | | 21.4 | | | |
| | | | | | | |
| PP-700-300 | | | | 45.0 | | |
| | | | | | | |
| DPP-600M | | | | | 30.2 | |
| | | | | | | |
| 2-Ethyl-4-methylimidazole | | 0.2 | 0.2 | 0.2 | 0.2 | 0.1 |
| Copper foil peeling strength | kg/cm | 2.0 | 1.8 | 1.7 | 1.8 | 2.0 |
| Solder resistance (260°C x 3 min.) | | No blister | No blister | No blister | No blister | No blister |
| Glass transition temperature | °C | 159 | 150 | 178 | 157 | 135 |
| Dielectric constant (1MHz) | | 4.23 | 4.29 | 4.05 | 4.12 | 4.91 |
| Dissipation factor (1MHz) | | 0.01 | 0.01 | 0.01 | 0.01 | 0.02 |

The cured resin of the epoxy resin composition of the present invention was excellent in heat resistance and low in dielectric and the copper-clad laminate obtained by molding it is suitable for multi-layer printed circuit boards for high-speed operational processing because of these excellent properties.

## Claims

1. An epoxy resin composition which comprises:
(1) a compound obtainable by previously reacting (A) an epoxy resin in an amount of from 30-95% by weight based on a total resin weight, said epoxy resin being obtainable by glycidyl etherifying a 3-methyl-6-(C₄-C₈)alkylphenol novolak represented by the following formula (4) : 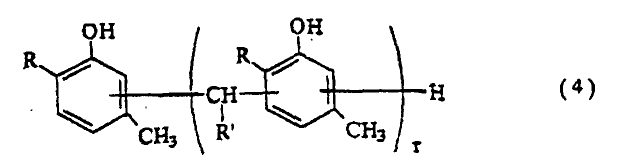 wherein R represents a C₄-C₈ alkyl group and R' represents an aldehyde residue, and r is 1.1-3,
with (B) a halogen-containing bisphenol compound in an amount sufficient to attain a UL flame retardancy rating of V-O, said halogen-containing bisphenol compound represented by the following formula (1): 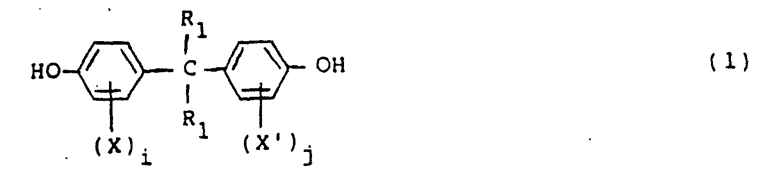 wherein R₁ represents a hydrogen atom or a methyl group and the two R₁ may be identical or different, X and X' represent halogen atom and may be identical or different, and i and j independently of one another are integers of 1 to 4 and
(2) an epoxy hardener.

2. An epoxy resin composition which comprises:
(1) a compound obtainable by previously reacting (A) the epoxy resin defined in claim 1, (B) the halogen-containing bisphenol compound defined in claim 1 and (C) a glycidyl etherification product of a halogen-containing bisphenol compound which is represented by the following formula (2): 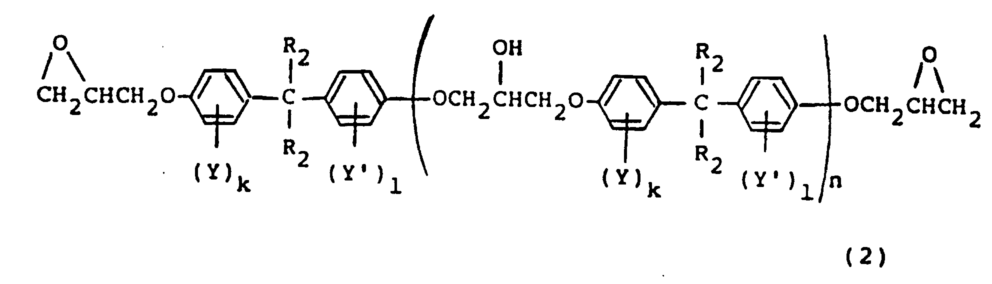 wherein R₂ represents a hydrogen atom or a methyl group and the two R₂ may be identical or different, Y and Y' represent halogen atom and may be identical or different, n represents an average recurring unit number and is 0 to 10 and k and l independently of one another are integers of 1 to 4 and
(2) an epoxy hardener.

3. An epoxy resin composition according to claim 1 or 2, wherein the epoxy hardener is a polybutadiene compound modified with a phenolic compound.

4. An epoxy resin composition according to claim 1 or 2, wherein the epoxy hardener is a dicyclopentadiene-phenol compound represented by the following formula (3): 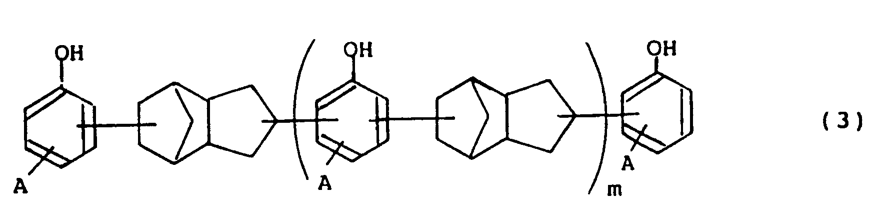 wherein m represents an average recurring unit number and is a numeral in the range of 0 to 10 and A represents a hydrogen atom or an alkyl group of 1 to 8 carbon atoms.

5. An epoxy resin copper-clad laminate obtained by heat molding a copper foil and a prepreg obtained by impregnating a substrate with a solution prepared by dissolving the epoxy resin composition of claim 1, 2, 3 or 4 in an organic solvent.

## Patentansprüche

1. Epoxidharzzusammensetzung, umfassend:
(1) eine Verbindung, die erhältlich ist durch vorausgehende Umsetzung von (A) einem Epoxidharz in einer Menge von 30-95 Gew.-%, bezogen auf das Gesamtharzgewicht, wobei das Epoxidharz durch Glycidyl-Veretherung eines 3-Methyl-6-(C₄-C₈)alkylphenol-novolaks der nachstehenden Formel (4) erhältlich ist, 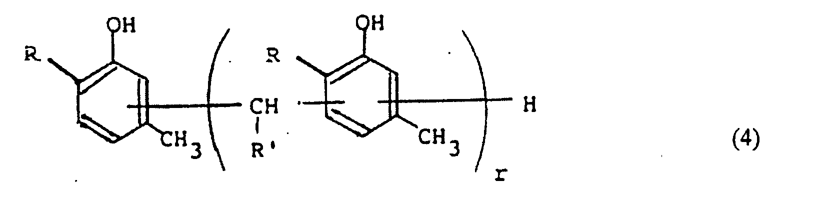 in der R für einen (C₄-C₈)-Alkylrest steht und R' einen Aldehydrest darstellt und r gleich 1,1-3 ist,
mit (B) einer halogenhaltigen Bisphenolverbindung in einer Menge, die ausreicht, um eine UL-Flammschutzklasse von V-O zu erreichen, wobei die halogenhaltige Bisphenolverbindung durch die nachstehende Formel (1) wiedergegeben wird, 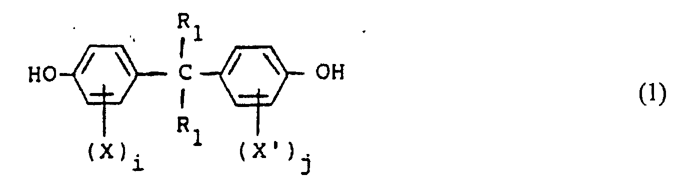 in der R₁ für ein Wasserstoffatom oder eine Methylgruppe steht und die beiden Reste R₁ gleich oder verschieden sein können, X und X' ein Halogenatom darstellen und gleich oder verschieden sein können, und i und j unabhängig voneinander ganze Zahlen von 1 bis 4 sind; sowie
(2) einen Epoxidhärter.

2. Epoxidharzzusammensetzung, umfassend:
(1) eine Verbindung, die erhältlich ist durch vorausgehende Umsetzung von (A) dem in Anspruch 1 definierten Epoxidharz, (B) der in Anspruch 1 definierten halogenhaltigen Bisphenolverbindung und (C) einem Glycidyl-Veretherungsprodukt einer halogenhaltigen Bisphenolverbindung, welches durch die nachstehende Formel (2) wiedergegeben wird 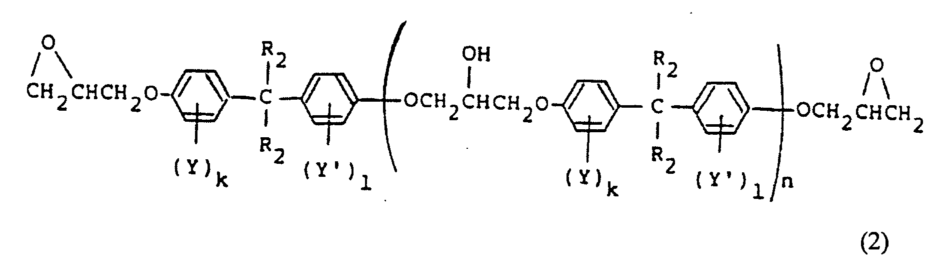 in der R₂ für ein Wasserstoffatom oder eine Methylgruppe steht und die beiden Reste R₂ gleich oder verschieden sein können, Y und Y' ein Halogenatom darstellen und gleich oder verschieden sein können, n eine mittlere Anzahl wiederkehrender Einheiten darstellt und 0 bis 10 beträgt, und k und l unabhängig voneinander ganze Zahlen von 1 bis 4 sind; sowie
(2) einen Epoxidhärter.

3. Epoxidharzzusammensetzung nach Anspruch 1 oder 2, wobei der Epoxidhärter eine mit einer phenolischen Verbindung modifizierte Polybutadienverbindung ist.

4. Epoxidharzzusammensetzung nach Anspruch 1 oder 2, wobei der Epoxidhärter eine Dicyclopentadien-Phenolverbindung der nachstehenden Formel (3) ist 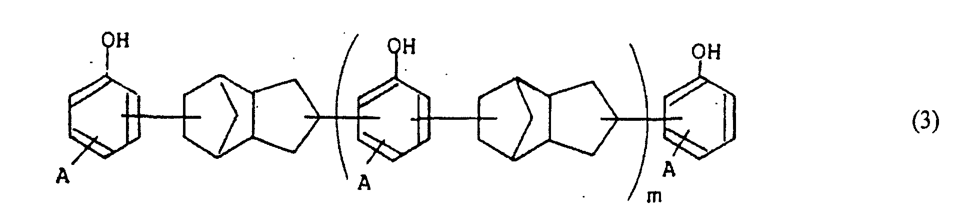 worin m eine mittlere Anzahl wiederkehrender Einheiten darstellt und ein Zahlenwert im Bereich von 0 bis 10 ist, und A für ein Wasserstoffatom oder einen Alkylrest mit 1 bis 8 Kohlenstoffatomen steht.

5. Kupferverkleidetes Epoxidharz-Laminat, erhalten durch Heißformen einer Kupferfolie und eines Prepregs, welches durch Imprägnieren eines Substrates mit einer Lösung erhalten wird, die durch Auflösen der Epoxidharzzusammensetzung nach Anspruch 1, 2, 3 oder 4 in einem organischen Lösungsmittel hergestellt ist.

## Revendications

1. Composition de résine époxy qui comprend:
(1) un composé que l'on peut obtenir par réaction préalable de (A) une résine époxy en une quantité comprise entre 30 et 95% en masse sur la base de la masse totale de résine époxy, ladite résine pouvant être obtenue par éthérification par un groupe glycidyle d'une 3-méthyl-6-(alkyl en C₄-C₈)phénol novolaque représentée par la formule suivante (4): 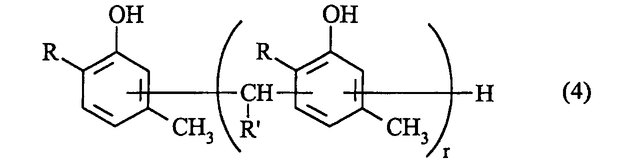 dans laquelle R représente un groupe alkyle en C₄-C₈ et R' représente un résidu aldéhyde et r est compris entre 1,1 et 3,
avec (B) un composé de bisphénol contenant des atomes d'halogène en une quantité suffisante pour atteindre une valeur de classement au feu UL égale à V-O, ledit composé de bisphénol contenant des atomes d'halogène étant représenté par la formule suivante (1): 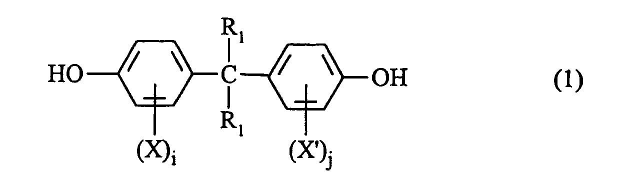 dans laquelle R₁ représente un atome d'hydrogène ou un groupe méthyle et les deux R₁ peuvent être identiques ou différents, X et X' représentent un atome d'halogène et ils peuvent être identiques ou différents et i et j sont indépendamment l'un de l'autre des entiers compris entre 1 et 4 et
(2) un agent de durcissement des résines époxy.

2. Composition de résine époxy qui comprend:
(1) un composé que l'on peut obtenir par réaction préalable de (A) la résine époxy définie dans la revendication 1, (B) le composé de bisphénol contenant des atomes d'halogène défini dans la revendication 1 et (C) un produit d'éthérification par un groupe glycidyle d'un composé bisphénol contenant des atomes d'halogène, qui est représenté par la formule suivante (2): 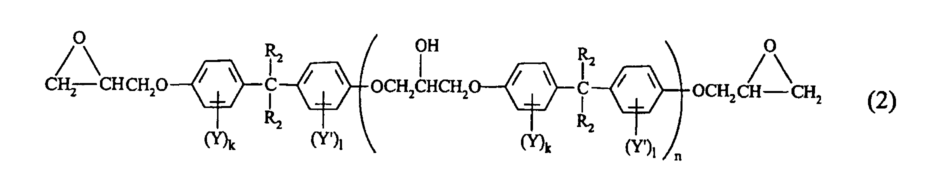 dans laquelle R₂ représente un atome d'hydrogène ou un groupe méthyle et les deux R₂ peuvent être identiques ou différents, Y et Y' représentent un atome d'halogène et ils peuvent être identiques ou différents, n représente un nombre moyen de motifs répétitifs et est compris entre 0 et 10 et k et l sont indépendamment l'un de l'autre des entiers compris entre 1 et 4 et
(2) un agent de durcissement des résines époxy.

3. Composition de résine époxy selon la revendication 1 ou 2, dans laquelle l'agent de durcissement des résines époxy est un composé polybutadiène modifié par un composé phénolique.

4. Composition de résine époxy selon la revendication 1 ou 2, dans laquelle l'agent de durcissement des résines époxy est un composé de dicyclopentadiène-phénol représenté par la formule suivante (3): 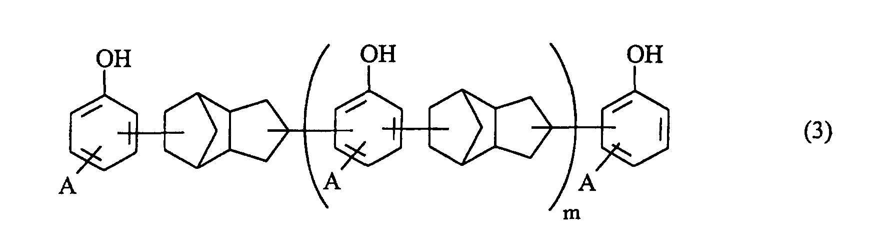 dans laquelle m représente un nombre moyen de motifs répétitifs et est un nombre dans l'intervalle compris entre 0 et 10 et A représente un atome d'hydrogène ou un groupe alkyle ayant de 1 à 8 atomes de carbone.

5. Stratifié de résine époxy recouvert de cuivre obtenu par moulage à chaud d'une feuille de cuivre et d'un produit pré-imprégné obtenu par imprégnation d'un substrat avec une solution préparée par dissolution de la composition de résine époxy de la revendication 1, 2, 3 ou 4 dans un solvant organique.
